# EUROPEAN PATENT SPECIFICATION

(11) **EP 1 771 599 B1**
(45) Date of publication and mention of the grant of the patent: **14.11.2007**
(21) Application number: 04770733.6
(22) Date of filing: 30.07.2004
(51) Int. Cl.: C23C 16/458, G01B 11/00

(54) **EPITAXIAL REACTOR WITH SUSCEPTOR CONTROLLED POSITIONING**
EPITAXIEREAKTOR MIT SUSZEPTORGESTEUERTER POSITIONIERUNG
REACTEUR EPITAXIAL A COMMANDE DE POSITIONNEMENT DE SUSCEPTEUR

(43) Date of publication of application: 11.04.2007
(73) Proprietor: LPE SPA, 20021 Bollate MI (IT)
(72) Inventor: PRETI, Franco, I-20133 Milano (IT); OGLIARI, Vincenzo, I-26010 Capergnanica (IT); TARENZI, Giuseppe, I-26823 Castiglione d'Adda (IT)
(74) Representative: Pistolesi, Roberto
(86) International application number: PCT/IT2004/000430
(87) International publication number: WO 2006/011169

(56) References cited:
- US-A- 5 982 986
- PATENT ABSTRACTS OF JAPAN vol. 009, no. 274 (E-354), 31 October 1985 (1985-10-31) & JP 60 117714 A (TOSHIBA KIKAI KK), 25 June 1985 (1985-06-25)
- PATENT ABSTRACTS OF JAPAN vol. 1998, no. 01, 30 January 1998 (1998-01-30) & JP 09 229624 A (TOTO LTD), 5 September 1997 (1997-09-05)

## Description

The invention relates to an epitaxial reactor used in the production of substrates by means of chemical vapour deposition (CVD); it also comprises a method for controlling the position of the susceptor of this reactor.

In the field of the reactors considered here, used above all in the microelectronics industry, the term "susceptor" indicates the heated support which accommodates the substrates (also commonly termed slices or wafers) during the process of epitaxial growth.

The susceptor is placed inside a reaction chamber usually made of quartz, while the substrates are located on its upper surface, inside respective seatings which, except for small clearances which can be used for positioning them, take on their shape (generally the shape of a disc).

As is known, epitaxial growth is the result of a chemical reaction between two or more gases, the reaction products of which are the pure material which is deposited and crystallises on the surface of the substrates: these reactions take place at very high temperatures, hence the necessity of heating the substrates by means of the susceptor.

To improve the uniformity of the layers deposited, a common practice is to use rotating susceptors; in this way the radial temperature and rate of growth profile is averaged along the azimuth coordinate, and is more uniform.

There are susceptors intended for one substrate only or for a number of substrates, the latter being used to increase the productivity of the reactor; furthermore, also to improve productivity, a known practice is to use a robotic arm for the operations of loading/unloading the substrates.

In this case, since the susceptor rotates during the process, a system is required to control its angular positioning so that it can be moved to a pre-arranged position, in order to permit loading/unloading operations; this angular movement is controlled electronically together with that of the robotic arm.

Considering the particular features of the CVD process, the system which brings about the angular positioning of the susceptor must not contaminate the reaction chamber by introducing metal particles into it or releasing others, for example because of sliding parts.

Another fundamental requirement is the capability which the positioning system must have of operating at high temperatures (above 1000°C) which are developed in the epitaxial reaction chamber.

In view of these stringent conditions, state-of-the-art systems for controlling the position of the susceptors are predominantly of the optical type.

One of them provides for a laser beam which is aimed from outside the reaction chamber towards the edge of the susceptor disc, which has a notch for this purpose; when the latter arrives below the laser beam as a result of the rotation of the susceptor, its presence is detected, enabling the position to be adjusted with the operations required for the purpose.

The various steps in the adjustment process are managed electronically with control units known in themselves.

Control systems of the type considered above are satisfactory from the point of view of angular positioning; however, they have limits as far as the mechanical strength of the susceptor is concerned.

To understand this, it has to be borne in mind that the latter is subject to high thermal stresses due to the heating cycles applied to it; the result is that the presence of the notch, following repeated expansion and contraction, may be a source of splits or cracks in the susceptor with all the undesirable consequences, easily imagined, which arise from this.

The problem addressed by the present invention is therefore that of producing an epitaxial reactor in which the angular position of the susceptor is free from the above-mentioned disadvantages.

The idea for solving this problem consists in producing a susceptor in which, instead of the notch or other similar reference provision which reduces the mechanical properties of the structure of the susceptor, an element is used which projects from its surface and is capable of reflecting the laser beam or other electromagnetic radiation used.

This projecting element, which in a preferred form is constituted by a pin with a widened head, is detected as a result of the variation in the path of the incident ray, which is changed compared with when it is reflected from the surface of the susceptor; the angular position of the latter is then adjusted, preferably by a method which constitutes part of the present invention.

The projecting element for reflecting the incident rays does not weaken the susceptor, since it rests on its surface and therefore does not impair its structure.

Moreover, this element is preferably produced from the same material as the susceptor so as to have the same characteristics of strength and reflectivity at the high temperatures of the gases present in the reaction chamber.

The advantages of the invention will become clear from the following description of a form of embodiment of the invention, provided purely by way of non-limiting example with reference to the appended drawings, in which:

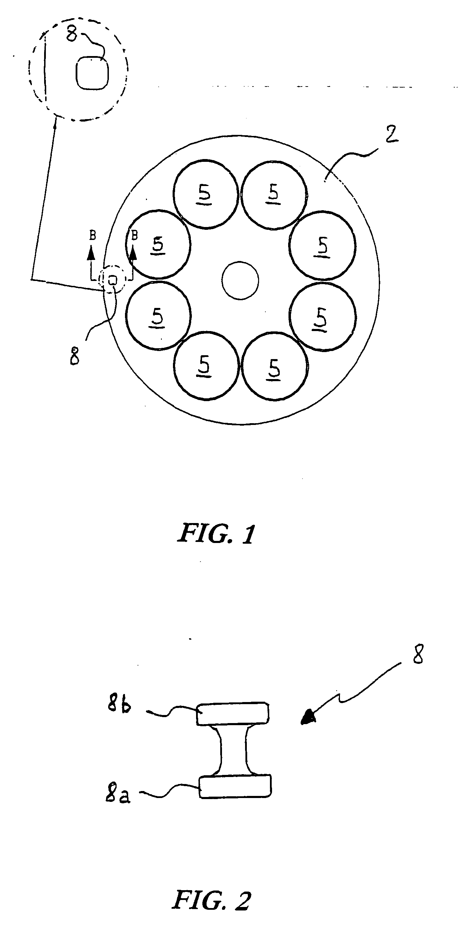

Figure 1 shows a view from above of a susceptor according to the present invention;
Figure 2 shows a view in section along the plane indicated by the line B-B in figure 1;
Figure 3 shows a view in section of the epitaxial reactor in which the susceptor in figure 1 is located;
Figure 4 illustrates schematically the reflection of a laser ray in the reactor in the previous drawing.

With particular reference to the third drawing, this shows an epitaxial reactor indicated as a whole by the number 1 which comprises a disc-shaped susceptor 2 housed in a reaction chamber 3 of substantially parallelepiped shape.

The susceptor is preferably produced from graphite and has a series of circular seatings 5 (in this case eight) to accommodate the substrates; this rotates about a vertical axis X, driven by an electronically controlled motor, not shown in the drawings as being known in itself. In practice, this is an electric motor coupled to a pulse generator (encoder) so as to divide the 360° rotation about the axis X into a number of predetermined intervals (for example 200 x10³).

The reactor 1 also comprises a robotic arm for loading the substrates onto the susceptor (and for unloading them from it); this arm is not shown in the drawings as it too is of a type known, for example, from European patent application 99962242.

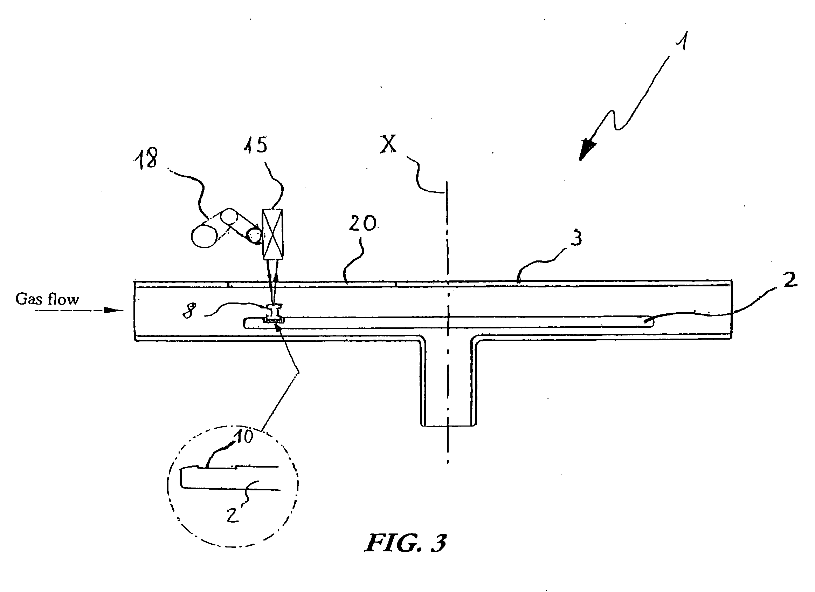

The reaction chamber 3 has walls of quartz and is open at opposite ends, to allow the flow of gas to pass through as indicated in figure 3.

On the edge of the susceptor, a pin 8 is fitted having a flat and broad base 8a and head 8b, which make it roughly bobbin-shaped, so as to ensure proper seating on the susceptor and good reflection of the laser ray, as will be explained more clearly in what follows.

According to this example of the invention, the pin base 8a is seated in a hollow 10 shown in the enlarged detail in figure 3, which is used to make the seating of the base 8a of the pin more stable and is substantially superficial.

On the outside of the reaction chamber 3, in a position above the pin 8, a module 15 is arranged, comprising a laser ray transmitter and receiver, known in themselves; preferably this module is supported by an actuator 18, of the pneumatic, electromechanical or other type, so that it can be moved between an operating position in which it directs the laser ray downwards towards the susceptor and a non-operating position in which it is moved away relative to the chamber 3.

Preferably, on the upper wall of the reaction chamber 3 through which the laser rays pass, the surface of the quartz is smooth so that irregularities in it are eliminated and an optical window 20 is produced which avoids phenomena of scattering of the laser ray, which would reduce the precision of the operation.

In the operating position, the module 15 transmits a laser beam at a predetermined angle of incidence onto the surface of the susceptor 2, which reflects it towards the detector present in the same module.

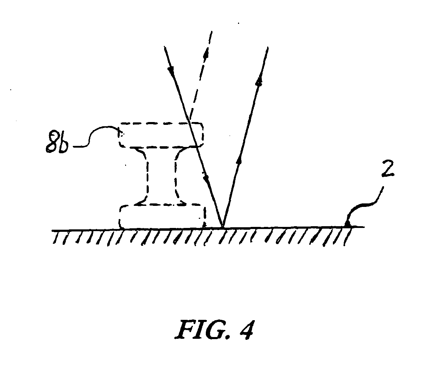

When as a result of rotation of the susceptor 2 the pin 8 passes under the module 15, the beam transmitted by the latter is reflected by the flat head 8b in a different manner, given that it projects relative to the surface of the susceptor 2; figure 4 illustrates schematically the different path of the same incident ray when it is reflected by the susceptor 2 and by the head 8b of the pin.

The difference in the path of the beam is detected by the module 15 which signals the presence of the pin to the electronic control unit (CPU) which controls the adjustment of the susceptor; this takes place on the basis of a program previously input into the control unit, with operating steps which in this example are the following.

As a first step, the system is initialised; for this, the susceptor 2 is made to rotate clockwise at low speed (3 revolutions/min), the laser beam being projected onto the surface and the values relating to the path of the beam being acquired for some seconds; by taking the mean of these values, a measurement is obtained of the mean distance of the surface of the susceptor from the from the laser module 15.

As soon as a distance value smaller by a predetermined amount than the above-mentioned mean distance is obtained, this means that the laser beam has fallen on the pin 8 and the adjustment is then carried out in this manner:
a) the susceptor 2 is slowed down with a speed reduction slope until it stops with a braking angle of approximately 100°/120°;
b) the susceptor 2 is rotated at low speed (1 revolution/min) in an anticlockwise direction, that is opposite to the previous one;
c) when as a result of the reverse rotation the beam once again falls on the pin 8, the angular position SZ1 of the susceptor is stored on the basis of the signal supplied by the pulse generator associated with the motor which rotates the susceptor;
d) the susceptor is slowed down until it stops rapidly (the braking space is approximately 11°/13°);
e) after this, with precision movements (speed 0.1 to 0.05 revolutions/min) of the susceptor, the pin 8 is brought back under the laser beam and this angular position becomes the 0° reference position which is used to initialise the pulse generator associated with the motor.

At this point, after the laser module 15 has been raised to the non-operating position, the operations of loading the substrates onto and unloading them from the susceptor with the robotic arm can be performed.

This is because the rotation of the susceptor 2 can be precisely controlled on the basis of the signals supplied by the pulse generator associated with the operating motor, to bring the seatings 5 into the position required for the loading/unloading of the substrates by the robotic arm.

In the light of what has been described so far it is therefore easy to understand how the control of the angular position carried out in accordance with the invention overcomes the limits pointed out in known reactors.

This is because the presence of the pin on the disc of the susceptor avoids the need for notching the edge of the latter, as explained at the outset; the consequence is that in this way the risk of cracks or breaks being formed or propagated due to the stresses induced by the thermal cycles to which the susceptor is subject are eliminated from the outset.

It may be noted moreover that the hollow 10 providing the seating for the pin has the effect of making the pin more stable but is not strictly necessary and could also be omitted; in that case it would only be necessary to widen the base 8a to obtain the same effect.

However, because the hollow 10 is shallow, it does not affect the structural strength of the susceptor.

In general it may be said that the body of the pin is preferably narrow in order not to interfere (or interfere as little as possible) with the reaction gases so as not to affect the fluid dynamics of the reactor, and to reduce the friction between the gases and the pin.

To obtain these effects, it would be possible to produce pins with a broad base and a narrower head, or to incorporate the pin directly in the susceptor as a protuberance of it.

Of course, other variants of the invention are possible with respect to what has been described so far.

Firstly it may be observed that the principles explained above are also valid for susceptors of material other than graphite, in which there may be problems of cracks and breaks caused by thermal stresses.

Further variations are also possible as regards the beam falling onto the susceptor and the method by which this is transmitted and detected; for example, it is quite possible that this beam may be other than a laser beam.

Finally, the invention is not to be considered as limited only to controlling the angular position of the susceptor, but may also be applied to linear control; more generally, it applies to reactors for chemical deposition from the vapour phase in which there are susceptors or other similar moving components where positioning has to be controlled.

## Claims

1. A reactor for chemical vapour deposition comprising a reaction chamber (3), a susceptor (2) which can be moved in this chamber, means (15) to transmit electromagnetic radiation towards the susceptor and means (15) to detect this radiation, **characterised in that** on the susceptor there is present at least one projecting reference element (8) seated thereon, capable of reflecting the radiation towards said means for detecting it.

2. A reactor according to claim 1, in which the means (15) for transmitting the electromagnetic radiation and those for detecting it are arranged outside the reaction chamber (3).

3. A reactor according to claim 2, in which the electromagnetic radiation is of the luminous type and the walls of the reaction chamber (3) are transparent to this radiation.

4. A reactor according to claim 3, in which the luminous radiation comprises a laser beam.

5. A reactor according to the preceding claims, in which said reflecting element comprises a pin (8) projecting relative to the surface of the susceptor (2).

6. A reactor according to claim 5, in which the pin comprises a flat head (8b).

7. A reactor according to claim 6, in which the pin comprises a base (8a) for seating it on the susceptor.

8. A reactor according to claim 7 in which the base (8a) of the pin (8) is seated in a hollow (10) formed on the surface of the susceptor (2).

9. A reactor according to the preceding claims, in which the reflecting element (8) is made of the same material as the susceptor.

10. A reactor according to claim 9, in which said material is graphite-based.

11. A reactor according to the preceding claims, in which the susceptor (2) rotates relative to an axis (X) and its rotational movement is brought about by electronically controlled initialisable operating means.

12. A reactor according to the preceding claims, in which the means for transmitting electromagnetic radiation towards the susceptor and those for detecting the radiation reflected by it are incorporated in a module (15) which can be moved between an operating position directed towards the susceptor (2) and a non-operating position in which said module is moved away relative to the reaction chamber (3).

13. A reactor according to the preceding claims, comprising a window (20) in the area of the reaction chamber (3) through which the electromagnetic radiation passes, capable of avoiding scattering of the radiation.

14. A susceptor for a reactor according to claims 1 to 13, **characterised in that** it comprises a hollow (10) on its face intended for the support of substrates, to provide a seating for a base (8a) of a projecting element (8) capable of reflecting said electromagnetic radiation.

15. A susceptor for a reactor according to claims 1 to 13, **characterised in that** it comprises a protuberance on its face intended for supporting substrates, capable of reflecting electromagnetic radiation.

16. A method for controlling the position of a susceptor (2) of a reactor for chemical vapour deposition , comprising the steps of:
- arranging an element (8) projecting from the surface of the susceptor, capable of reflecting electromagnetic radiation;
- projecting a beam of electromagnetic radiation onto the susceptor (2) in motion;
- detecting the difference of the path of the beam when it is reflected by the projecting element (8);
- inputting the position of the susceptor (2) following the detection of the different path of the beam;
- causing movement of the susceptor (2) on the basis of the position input.

17. A method according to claim 16, also comprising the following steps for inputting the position of the susceptor:
- moving the susceptor (2) for a predetermined time, acquiring the mean of the values of the distance travelled by the incident beam;
- halting the susceptor (2) in a predetermined space when this distance varies as a result of the reflecting element (8) passing under the beam;
- moving the susceptor (2) backwards, returning the reflecting element (8) into the position under the beam;
- initialising the susceptor (2) using this position as reference.

## Patentansprüche

1. Reaktor für chemische Dampfablagerung, welcher eine Reaktionskammer (3) aufweist, einen Suszeptor (2), der in dieser Kammer bewegt werden kann, eine Vorrichtung (15) zum Senden elektromagnetischer Strahlung zu dem Suszeptor und eine Vorrichtung (15) zum Erfassen dieser Strahlung, **dadurch gekennzeichnet, dass** auf dem Suszeptor zumindest ein vorstehendes Bezugselement (8) aufsitzt, welches die Strahlung zu der Vorrichtung für deren Erfassung reflektieren kann.

2. Reaktor nach Anspruch 1, bei welchem die Vorrichtung (15) zum Senden der elektromagnetischen Strahlung und jene zu deren Erfassung außerhalb der Reaktionskammer (3) angeordnet sind.

3. Reaktor nach Anspruch 2, bei welchem die elektromagnetische Strahlung vom Lichttyp ist, und die Wände der Reaktionskammer (3) für diese Strahlung transparent sind.

4. Reaktor nach Anspruch 3, bei welchem die Lichtstrahlung einen Laserstrahl aufweist.

5. Reaktor nach den voranstehenden Ansprüchen, bei welchem das reflektierende Element einen Stift (8) aufweist, der relativ zur Oberfläche des Suszeptors (2) vorsteht.

6. Reaktor nach Anspruch 5, bei welchem der Stift einen flachen Kopf (8b) aufweist.

7. Reaktor nach Anspruch 6, bei welchem der Stift eine Basis (8a) aufweist, um ihn auf den Suszeptor aufzusetzen.

8. Reaktor nach Anspruch 6, bei welchem die Basis (8a) des Stiftes (8) in einer Vertiefung (10) einsitzt, die auf der Oberfläche des Suszeptors (2) vorgesehen ist.

9. Reaktor nach den voranstehenden Ansprüchen, bei welchem das reflektierende Element (8) aus demselben Material wie der Suszeptor besteht.

10. Reaktor nach Anspruch 9, in welchem das Material ein Material auf Graphitgrundlage ist.

11. Reaktor nach den voranstehenden Ansprüchen, bei welcher sich der Suszeptor (2) relativ zu einer Achse (X) dreht, und seine Drehbewegung durch eine elektronisch gesteuerte, initialisierbare Betätigungsvorrichtung hervorgerufen wird.

12. Reaktor nach den voranstehenden Ansprüchen, bei welchem die Vorrichtung zum Senden elektromagnetischer Strahlung zum Suszeptor und jene zur Erfassung der Strahlung, die von ihm reflektiert wird, in einem Modul (15) vereinigt sind, welches zwischen einer Betriebsposition, gerichtet zum Suszeptor (2) hin, und einer nicht betriebsfähigen Position bewegt werden kann, an welcher das Modul weg relativ zu Reaktionskammer (3) bewegt wird.

13. Reaktor nach den voranstehenden Ansprüchen, welcher ein Fenster (20) im Bereich der Reaktionskammer (3) aufweist, durch welches die elektromagnetische Strahlung hindurchgeht, und welches eine Streuung der Strahlung verhindern kann.

14. Suszeptor für einen Reaktor nach den Ansprüchen 1 bis 13, **dadurch gekennzeichnet, dass** er eine Vertiefung (10) auf seiner Oberfläche aufweist, die für das Haltern von Substraten gedacht ist, um einen Sitz für eine Basis (8a) eines vorstehenden Elements (8) zur Verfügung zu stellen, welches die elektromagnetische Strahlung reflektieren kann.

15. Suszeptor für einen Reaktor nach den Ansprüchen 1 bis 13, **dadurch gekennzeichnet, dass** er einen Vorsprung auf seiner Oberfläche aufweist, die für das Haltern von Substraten gedacht ist, welcher elektromagnetische Strahlung reflektieren kann.

16. Verfahren zum Steuern der Position eines Suszeptors (2) eines Reaktors für chemische Dampfablagerung, mit folgenden Schritten:
- Anordnen eines Elements (8), das gegenüber der Oberfläche des Suszeptors vorsteht, und elektromagnetische Strahlung reflektieren kann;
- Projizieren eines Strahls elektromagnetischer Strahlung auf den in Bewegung befindlichen Suszeptor (2);
- Erfassung der Differenz des Weges des Strahls, wenn er von dem vorstehenden Element (8) reflektiert wird;
- Eingabe der Position des Suszeptors (2) nach der Erfassung des unterschiedlichen Weges des Strahls;
- Hervorrufen einer Bewegung des Suszeptors (2) auf der Grundlage der Positionseingabe.

17. Verfahren nach Anspruch 16, welches weiterhin die folgenden Schritte zur Eingabe der Position des Suszeptors aufweist:
- Bewegen des Suszeptors (2) über eine vorbestimmte Zeit, Akquirieren des Mittelwertes der Werte der Entfernung, die von dem einfallenden Strahl zurückgelegt wird;
- Anhalten des Suszeptors (2) in einem vorbestimmten Raum, wenn sich diese Entfernung als Ergebnis der Tatsache ändert, dass das reflektierende Element (8) unter dem Strahl hindurchgeht;
- Bewegen des Suszeptors (2) rückwärts, Zurückstellen des reflektierenden Elements (8) in die Position unter dem Strahl;
- Initialisieren des Suszeptors (2) unter Verwendung dieser Position als Bezugsgröße.

## Revendications

1. Réacteur pour le dépôt chimique en phase vapeur comprenant une chambre de réaction (3), un suscepteur (2) qui peut être déplacé dans cette chambre, des moyens (15) pour transmettre le rayonnement électromagnétique vers le suscepteur et des moyens (15) pour détecter ce rayonnement, **caractérisé en ce que**, sur le suscepteur, on trouve au moins un élément de référence en saillie (8), pouvant refléter le rayonnement vers lesdits moyens pour le détecter.

2. Réacteur selon la revendication 1, dans lequel les moyens (15) pour transmettre le rayonnement électromagnétique et ceux pour le détecter, sont agencés à l'extérieur de la chambre de réaction (3).

3. Réacteur selon la revendication 2, dans lequel le rayonnement électromagnétique est du type lumineux et les parois de la chambre de réaction (3) sont transparentes à ce rayonnement.

4. Réacteur selon la revendication 3, dans lequel le rayonnement lumineux comprend un faisceau laser.

5. Réacteur selon les revendications précédentes, dans lequel ledit élément réfléchissant comprend une broche (8) faisant saillie par rapport à la surface du suscepteur (2).

6. Réacteur selon la revendication 5, dans lequel la broche comprend une tête plate (8b).

7. Réacteur selon la revendication 6, dans lequel la broche comprend une base (8a) pour l'installer sur le suscepteur.

8. Réacteur selon la revendication 7, dans lequel la base (8a) de la broche (8) est installée dans un creux (10) formé sur la surface du suscepteur (2).

9. Réacteur selon les revendications précédentes, dans lequel l'élément réfléchissant (8) est réalisé avec le même matériau que le suscepteur.

10. Réacteur selon la revendication 9, dans lequel ledit matériau est à base de graphite.

11. Réacteur selon les revendications précédentes, dans lequel le suscepteur (2) tourne par rapport à un axe (X) et son mouvement de rotation est provoqué par des moyens de fonctionnement pouvant être initialisés, contrôlés électroniquement.

12. Réacteur selon les revendications précédentes, dans lequel les moyens pour transmettre le rayonnement électromagnétique vers le suscepteur et ceux pour détecter le rayonnement réfléchi par celui-ci, sont incorporés dans un module (15) qui peut être déplacé entre une position de fonctionnement dirigée vers le suscepteur (2) et une position inactive dans laquelle ledit module est éloigné par rapport à la chambre de réaction (3).

13. Réacteur selon les revendications précédentes, comprenant une fenêtre (20) dans la zone de la chambre de réaction (3), à travers laquelle le rayonnement électromagnétique passe, capable d'éviter la dispersion du rayonnement.

14. Suscepteur pour un réacteur selon les revendications 1 à 13, **caractérisé en ce qu'**il comprend un creux (10) sur sa face, prévu pour le support de substrats, afin de proposer un siège pour une base (8a) d'un élément de projection (8) capable de réfléchir ledit rayonnement électromagnétique.

15. Suscepteur pour un réacteur selon les revendications 1 à 13, **caractérisé en ce qu'**il comprend une protubérance sur sa face, prévue pour supporter des substrats, capable de réfléchir le rayonnement électromagnétique.

16. Procédé pour contrôler la position d'un suscepteur (2) d'un réacteur pour le dépôt chimique en phase vapeur, comprenant les étapes consistant à :
- agencer un élément (8) faisant saillie à partir de la surface du suscepteur, capable de réfléchir le rayonnement électromagnétique ;
- projeter un faisceau de rayonnement électromagnétique sur le suscepteur (2) en mouvement ;
- détecter la différence de la trajectoire du faisceau lorsqu'il est réfléchi par l'élément de projection (8) ;
- introduire la position du suscepteur (2) suite à la détection de la trajectoire différente du faisceau ;
- provoquer le mouvement du suscepteur (2) en fonction de l'entrée de position.

17. Procédé selon la revendication 16, comprenant également les étapes suivantes pour introduire la position du suscepteur, consistant à:
- déplacer le suscepteur (2) pendant un temps prédéterminé, acquérir la moyenne des valeurs de la distance parcourue par le faisceau incident ;
- arrêter le suscepteur (2) dans un espace prédéterminé lorsque cette distance varie en raison de l'élément réfléchissant (8) qui passe sous le faisceau ;
- déplacer le suscepteur (2) en arrière, faisant revenir l'élément réfléchissant (8) dans la position sous le faisceau ;
- initialiser le suscepteur (2) en utilisant cette position à titre de référence.
